(19) Europäisches Patentamt

European Patent Office

Office européen des brevets

(11) **EP 4 625 790 A1**

(12) **EUROPEAN PATENT APPLICATION**

(43) Date of publication:
01.10.2025 Bulletin 2025/40

(21) Application number: 25166726.7

(22) Date of filing: 27.03.2025

(51) International Patent Classification (IPC):
$H02M\ 1/00$ (2006.01)    $H02M\ 3/158$ (2006.01)
$H02M\ 3/07$ (2006.01)

(52) Cooperative Patent Classification (CPC):
H02M 3/158; H02M 1/0009; H02M 3/071

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 28.03.2024 US 202418620317

(71) Applicants:
• Nexperia B.V.
6534 AB Nijmegen (NL)
• Nexperia Technology (Shanghai) Ltd.
Shanghai 200025 (CN)

(72) Inventors:
• Olivares, Jairo
Dallas (US)
• Vera, Alejandro
Dallas (US)
• Deligoz, Ilker
Phoenix (US)

(74) Representative: Pjanovic, Ilija
Nexperia B.V.
Legal & IP
Jonkerbosplein 52
6534 AB Nijmegen (NL)

(54) **VALLEY CURRENT LIMIT DETECTION SCHEME FOR SWITCHING REGULATORS**

(57) A valley current limit circuit of a switching regulator is provided, with the valley current limit circuit including a sample and hold capacitor. The valley current limit circuit is arranged to charge the sample and hold capacitor when a low-side switch of the switching regulator is OFF and to provide a negative reference voltage from the sample and hold capacitor when the low-side switch is ON. The valley current limit circuit includes a comparator arranged to provide a current limit reference by comparing the negative reference voltage against a switch node voltage of the switching regulator when the low-side switch is ON.

FIG.2

EP 4 625 790 A1

**Description**

**BACKGROUND**

1. Field of the Disclosure

The present disclosure relates to buck converters. More specifically, the present disclosure relates to a valley current limit detection scheme for switching regulators, such as buck converters.

2. Description of the related art

A buck converter, also known as a step-down converter, is a type of direct current (DC) to DC converter circuit used to efficiently step down a higher input voltage to a lower output voltage. It is widely used in various applications such as power supplies, battery chargers and voltage regulators. The basic operation of a buck converter involves the controlled switching of a switching element to regulate the output voltage. The switching element typically consists of a high-side switch and a low-side switch, e.g., a transistor, metal-oxide-semiconductor field-effect transistor (MOSFET) or power FET. These switches play crucial roles in controlling the flow of current through the converter and regulating the output voltage.

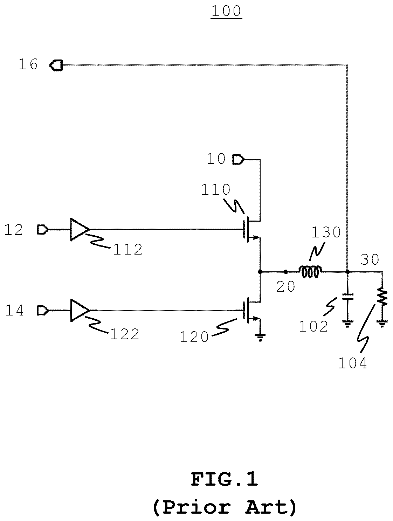

Fig. 1 shows a part of an example buck converter 100 including a high-side switch 110 driven by a high-side driver circuit 112 under control of a high-side control signal 12 (also referred to as high-side ON, HSON, signal) and a low-side switch 120 driven by a low-side driver circuit 122 under control of a low-side control signal 14 (also referred to as low-side ON, LSON, signal). When the high-side switch 110 is ON, the high-side switch 110 provides input voltage ($V_{in}$) 10 to the switch node (SW) 20; the low-side switch 120 is then in an OFF state. When the high-side switch 110 is OFF, the low-side switch 120 is in an ON state.
Output voltage ($V_{out}$) 30 may be generated via an inductor 130, which is typically connected to an output capacitor 102 and a load (e.g., resistor) 104. $V_{out}$ 30 may be looped back as a loop voltage 16. When the high-side switch 110 is turned ON, current flows from $V_{in}$ 10 through the inductor 130, storing energy in the magnetic field. Turning the high-side switch 110 OFF interrupts the flow of current from $V_{in}$ 10, causing the inductor current to flow through the load 104 and the output capacitor 102, thereby providing power to the load 104. The high-side switch 110 can operate at high voltage levels and often requires specialized gate driving circuitry 112, especially in applications where $V_{in}$ 10 is significantly higher than $V_{out}$ 30.
The low-side switch 120 is placed between the inductor 130 and a ground reference. Its primary function is to control the discharge of the inductor current during the OFF state of the high-side switch 110. When the low-side switch 120 is turned ON, it provides a path for the inductor current to flow through, completing the circuit and allowing the inductor current to decrease gradually. Turning the low-side switch 120 OFF isolates the inductor 130 from the ground, allowing the inductor current to flow through the load 104 and the output capacitor 102, supplying power to the load 104.
The low-side switch 120 typically operates at lower voltage levels compared to the high-side switch 110, but it also needs to handle the full load current.
SW 20 refers to the point where the switching element 110, 120 connects to the inductor 130. The voltage at SW 20 switches between high and low states based on the switching action of the switching element 110, 120. This switching action is what allows the buck converter to regulate $V_{out}$ 30 by controlling the duty cycle of the switching element 110, 120. Together, the high-side switch 110 and the low-side switch 120 control the switching action of the buck converter 100, regulating the flow of energy from $V_{in}$ 10 to the output load 104 and maintaining the desired $V_{out}$ 30. Proper coordination and timing between these switches 110, 120 are essential for efficient and reliable operation of the buck converter 100.
A valley limit refers to a specific condition during the switching cycle where the inductor current reaches its minimum value. This condition is critical for the proper operation of the buck converter 110. When the high-side switch 110 turns OFF, the inductor current of the inductor 130 flows through the load 104 and the output capacitor 102, causing the inductor current to decrease. This decreasing current continues until it reaches its minimum value, known as the valley current. The valley limit is a design consideration in buck converters to ensure that the inductor current doesn't drop too low during the OFF state of the high-side switch 110. If the inductor current falls below a certain threshold, it may not have enough energy stored to adequately supply the load during the next ON state of the high-side switch 110, possibly leading to instability or improper operation of the buck converter 110. The valley limit may be used to control the high-side control signal (HSON) 12 and the low-side control signal (LSON) 14.

**SUMMARY**

A summary of aspects of certain examples disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects and/or a combination of aspects that may not be set forth.

In a switching regulator, such as a buck converter, it is advantageous to sense and limit the current when the low-side power FET is ON and current is discharging to the output. This can help prevent current runaway at very low duty cycles. In known solutions, a lossy sense resistor or complex circuitry may be required to generate the valley current reference since this value will be negative. The present disclosure presents an improved solution that does not require such lossy sense resistor or complex circuitry.

According to an aspect of the present disclosure, a valley current limit circuit of a switching regulator is presented. The valley current limit circuit may include a sample and hold capacitor. The valley current limit circuit may be arranged to charge the sample and hold capacitor when a low-side switch of the switching regulator is OFF and to provide a negative reference voltage ($V_{REF\_NEG}$) from the sample and hold capacitor when the low-side switch is ON. The valley current limit circuit may include a comparator arranged to provide a current limit reference ($I_{LIM}$) by comparing the $V_{REF\_NEG}$ against a switch node voltage (Vsw) of the switching regulator when the low-side switch is ON.

In an embodiment, the switching regulator may be a buck converter.

In an embodiment, the valley current limit circuit may further include a sense FET. A drain of the sense FET may be connected to a reference voltage ($V_{DD}$). A gate of the sense FET may be connected to the $V_{DD}$. A source of the sense FET may be connected to ground. One side of the sample and hold capacitor may be connected to the drain of the sense FET for charging the sample and hold capacitor using a reference current ($I_{REF}$), with $I_{REF}$ being the result of the $V_{DD}$ on the sense FET.

In an embodiment. the sense FET and the low-side switch may be proportional, i.e. proportionally dimensioned.

In an embodiment, the valley current limit circuit may include first switches and second switches. The valley current limit circuit may be arranged to close the first switches and open the second switches when the low-side switch is OFF, thereby connecting the one side of the sample and hold capacitor to the drain of the sense FET and connecting the other side of the sample and hold capacitor to ground. The valley current limit circuit may be arranged to open the first switches and close the second switches when the low-side switch is ON, thereby connecting the one side of the sample and hold capacitor to ground and connecting the other side of the sample and hold capacitor to the comparator.

In an embodiment, the valley current limit circuit may further include a phase generator. The phase generator may be arranged to generate a first signal for controlling switching of the first switches. The phase generator may further be arranged to generate a second signal for controlling switching of the second switches. The first signal and the second signal may be non-overlapping inverse signals.

In an embodiment, when the first signal is LOW the second signal is HIGH, and when the first signal is HIGH the second signal is LOW. There may be a delay between the first signal and the second signal to ensure that the first signal and the second signal are non-overlapping.

In an embodiment, the comparator may be arranged to operate under control of the first signal and the second signal.

In an embodiment, the comparator may be an auto zero comparator.

According to an aspect of the present disclosure a switching regulator, such as a buck converter, is presented. The switching regulator may include a high-side switch. The switching regulator may further include a low-side switch. The switching regulator may further include a switch node (SW) located in between the high-side switch and the low-side switch. The switching regulator may further include an inductor connected to the SW, the inductor providing an output voltage (Vout) depending on the high-side switch being turned ON or the low-side switch being turned ON. The switching regulator may further include a valley current limit circuit having one or more of the above described features. The valley current limit circuit may be arranged to provide a current limit reference ($I_{LIM}$) for regulating a high-side control signal (HSON). The HSON signal may be used for controlling the switching of the high-side switch.

In an embodiment, the high-side switch and the low-side switch may be MOSFETs.

In an embodiment, the valley current limit circuit may include a sense FET that is proportional to the low-side switch, such that Rds_low_side_switch_120 : Rds_sense_FET_210 = 1:K.

## BRIEF DESCRIPTION OF THE DRAWINGS

Embodiments of the present disclosure will now be described, by way of example only, with reference to the accompanying schematic drawings in which corresponding reference symbol indicate corresponding parts, in which:

Fig. 1 schematically shows a part of a known buck converter.
Fig. 2 schematically shows a valley current limit circuit according to an example embodiment of the present disclosure.
Figs. 3-4 schematically shows example buck converters according to example embodiments of the present disclosure.
Fig. 5 schematically shows a phase generator.

The figures are intended for illustrative purposes only, and do not serve as restriction of the scope of the protection as laid down by the claims.

## DETAILED DESCRIPTION

It will be readily understood that the components of the embodiments as generally described herein and illustrated in the appended figures could be arranged and designed in a wide variety of different configurations. Thus, the following more detailed description of various embodiments, as represented in the figures, is not intended to limit the scope of the present disclosure but is merely representative of various embodiments. While the various aspects of the embodiments are presented in drawings, the drawings are not necessarily drawn to scale unless specifically indicated.

The described embodiments are to be considered in all respects only as illustrative and not restrictive. The scope of the present disclosure is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present disclosure should be or are in any single example of the present disclosure. Rather, language referring to the features and advantages is understood to mean that a specific feature, advantage, or characteristic described in connection with an embodiment is included in at least one embodiment of the present disclosure. Thus, discussions of the features and advantages, and similar language, throughout this specification may, but do not necessarily, refer to the same example.

Furthermore, the described features, advantages, and characteristics of the present disclosure may be combined in any suitable manner in one or more embodiments. One skilled in the relevant art will recognize, in light of the description herein, that the present disclosure may be practiced without one or more of the specific features or advantages of a particular embodiment. In other instances, additional features and advantages may be recognized in certain embodiments that may not be present in all embodiments of the present disclosure. Reference throughout this specification to "one embodiment," "an embodiment," or similar language means that a particular feature, structure, or characteristic described in connection with the indicated embodiment is included in at least one embodiment of the present disclosure. Thus, the phrases "in one embodiment," "in an embodiment," and similar language throughout this specification may, but do not necessarily, all refer to the same embodiment.

The present disclosure presents a valley current limit circuit based on a sense FET and a sampling capacitor to generate the negative voltage reference needed to detect a valley current limit for a switching regulator, such as a buck converter. By using a sense FET, a current source, a sample and hold capacitor, and phase generation logic, the negative current reference required to set the valley limit may be generated. The solution of the present disclosure takes advantage of the dual phase nature of the switching converter (high-side switch ON, and low-side switch ON) to sample a positive sense FET current. During the phase where the low side turns ON, the valley current limit circuit may swap the top plate of the sample and hold capacitor to ground and generate a negative current limit reference. Thus, an accurate, clean negative reference may be obtained without the use of a lossy resistor or any complex circuitry.

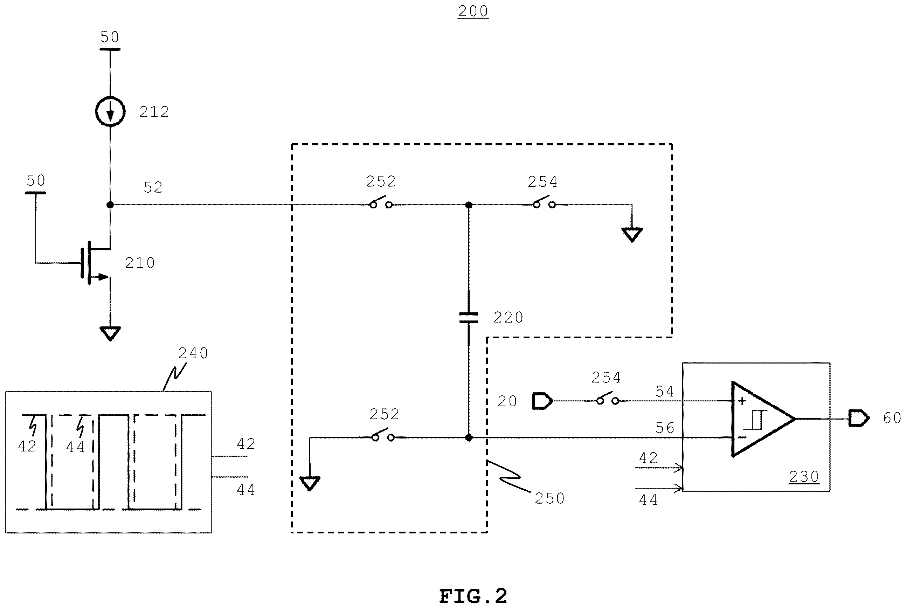

Fig. 2 shows an example embodiment of a valley current limit circuit 200 of the present disclosure. The valley current limit circuit 200 may include a sense FET 210, a sample and hold capacitor 220, a comparator 230 and a phase generator 240. Preferably, the comparator 230 is an auto-zero comparator.

A reference voltage ($V_{DD}$) 50 may be applied to the drain and gate of the sense FET 210. The source of the sense FET 210 may be connected to ground. The $V_{DD}$ enables a reference current ($I_{REF}$) 52 depicted by current reference 212.

A switch node voltage (Vsw) 54 from an SW 20 and a negative reference voltage ($V_{REF\_NEG}$) 56 may be input to the comparator 230. The SW 20 may be the same as the SW 20 of Fig. 1. The Vsw 54 may be applied to the comparator 230 under control of a switch 254. The comparator 230 may operate under control of phase signals 42, 44 originating from the phase generator 240. A first signal may be a phase A signal 42 and a second signal may be a phase B signal 44.

The comparator 230 may output a current limit reference ($I_{LIM}$) 60 that may be used by the buck converter to control a high-side control signal, such as the high-side control signal 12 of Fig. 1, and/or a low-side control signal, such as the low-side control signal 14 of Fig. 1.

In Fig. 2, the phase generator 240 is shown with its outputs 42, 44, which are to be understood to be connected to the switches 252, 254 and the comparator 230 as described herein. The valley current limit circuit 200 includes switches 252, 254 that may be controlled by the phase signals 42, 44 from the phase generator 240. First switches, such as phase A switches 252, may be switched ON and OFF under control of the first signal, such as the phase A signal 42. Second switches, such as phase B switches 254, may be switched ON and OFF under control of the second signal, such as the phase B signal 44. The switches together with the sample and hold capacitor 220 may be referred to as the switched capacitor negative reference generator 250.

The $I_{REF}$ 52 may be generated and sourced into the sense FET 210. Preferably, the sense FET 210 is a proportional sense FET, i.e., of same type as the low-side FET (e.g., the low-side switch 120) of the buck converter. The resulting voltage from $I_{REF}$ 52 may represent the reference threshold of the valley current limit.

In an example embodiment, the phase A signal 42 may be HIGH when the inductor current is charging up through the inductor of the buck converter, such as inductor 130, and the high-side FET, such as high-side switch 110. When the phase A signal is generated to be HIGH, the phase B signal is generated to be LOW. During this phase the phase A switches 252 may be closed and the phase B switches 254 may be open. As a result, the sampling capacitor 220 will sample the $I_{REF}$ 52 value (referenced to ground).

When the phase A signal 42 becomes LOW and phase B signal 44 becomes HIGH, the low-side FET, such as the low-site switch 120, will turn ON and the high-side FET will turn OFF and the inductor current will start to discharge. In this phase the phase A switches 252 will be open and the phase B switches 254 will be closed. As a result, the top plate of the sample and hold capacitor 220 will connect to ground instead of $I_{REF}$ 52. This in turn will produce an opposite polarity (negative in this case) $V_{REF\_NEG}$ 56 proportional to $I_{REF}$ 52. In this phase the comparator 230 receives the Vsw 54 from the SW 20 and trip whenever the SW 20 reaches the same voltage as $V_{REF\_NEG}$ 56.

Thus, a positive reference voltage $V_{DD}$ 50 may be sampled on the sample and hold capacitor 220 and the polarity may be flipped during the LSON measurement phase.

Advantageously, the solution of the present disclosure does not require a sense resistor to sense the valley current when the low-side FET is ON. Also, there is no need for any complex circuitry to process and/or generate the negative voltage reference to trigger the comparator. Usually, a level shifter or negative rail would be required to generate this negative voltage. With the sample and hold capacitor 220, this capacitor 220 will store the reference value and generate the correct negative value using switches 252, 254.

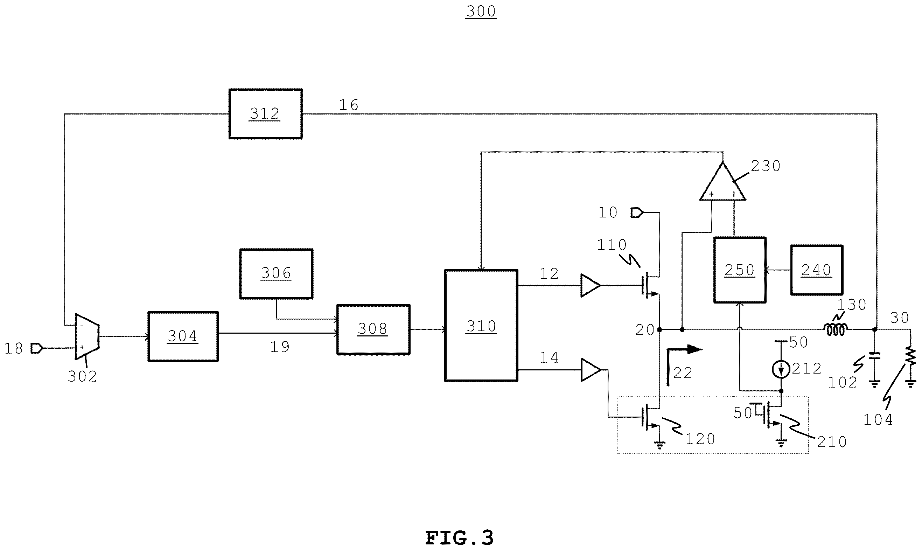

Fig. 3 shows a non-limiting example embodiment of a switching regulator, in this example a buck converter 300, implementing a valley current limit circuit, such as the valley current limit circuit 200 of Fig. 2. The buck converter 300 may include an error amplifier 302 having as inputs a loop reference voltage (Loop $V_{ref}$) 18 and a loop voltage 16 via a feedback gain element 312. The output of the error amplifier 302 may be input to a compensation network element 304 to generate a compensation voltage ($V_{comp}$) 19. A modulator element 308 may receive the $V_{comp}$ 19 together with a slope compensation generated by a slope compensation element 306. Output of the modulator element 308 may be input to a logic element 310, which controls the operation of the high-side switch 110 and low side-switch 120 via the gate driver circuits 112, 122 using the control signals HSON 12, LSON 14, respectively. When the high-side switch 110 is ON, the high-side switch provides the $V_{in}$ 10 to the SW 20. The low-side switch 120 is then in an OFF state. When the high-side switch 110 is OFF, the low-side switch 120 is ON. The $V_{out}$ 30 may be generated via the inductor 130, which is typically connected to the capacitor 102 and a load (e.g., resistor) 104. $V_{out}$ 30 may be looped back via the feedback gain element 312.

The logic element 310 may further use the output of the valley current limit circuit 200 to determine when the HSON signal 12 and LSON signal 14 are to be generated. Hereto, the $I_{LIM}$ 60 generated by the valley current limit circuit 200 may be input to the logic element 310. In Fig. 3, the dashed line around the low-side switch 120 and the sense FET 210 indicate that these are proportional, e.g., with $R_{ds\_low\_side\_switch\_120}$ : $R_{ds\_sense\_FET\_210}$ = 1:K, with $R_{ds}$ being the drain-source resistance, also known as Rds(on). Consequently, the following may apply:

$$I_{low\text{-}side\_switch\_120} \times R_{ds\_low\text{-}side\_switch\_120} = K \times R_{ds\_sense\_FET\_210} \times I_{REF\_52},$$

with $I_{low\text{-}side\_switch\_120}$ 22 being the current through the low-side switch 120 when it is ON, $R_{ds\_low\text{-}side\_switch\_120}$ being the $R_{ds}$ of the low-side switch 120, K being the proportion factor, $R_{ds\_sense\_FET\_210}$ being the $R_{ds}$ of the sense FET 210 and $I_{REF\_52}$ 52 being the reference threshold of the valley current limit at the current reference 212.

In Fig. 3, the valley current limit circuit 200 is shown including the switched capacitor negative reference generator 250, which may include the switches 252, 254 and sample and hold capacitor 220 as shown in Fig. 2.

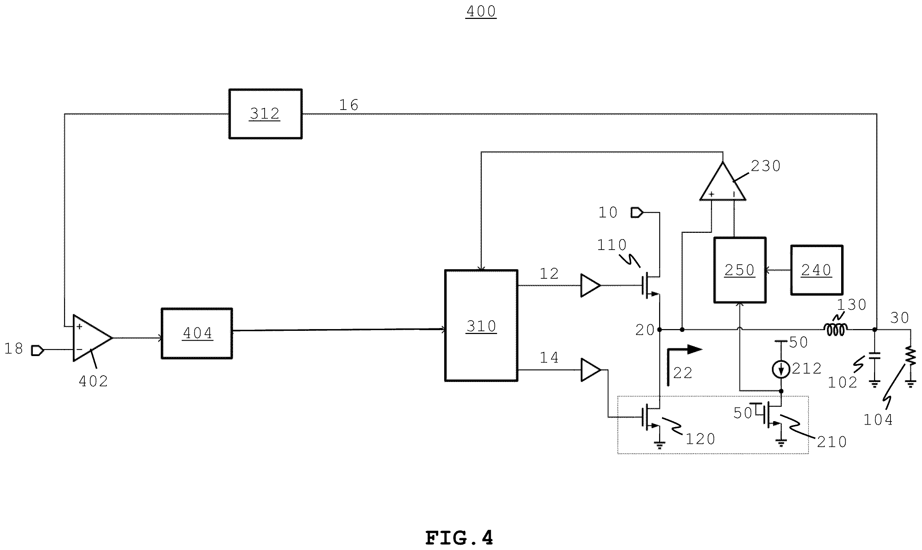

Fig. 4 shows another non-limiting example embodiment of a buck converter 400 according to the present disclosure. The buck converter 400 may include a loop comparator 402 having as inputs the Loop $V_{ref}$ 18 and the loop voltage 16 via feedback gain element 312. The output of the loop comparator 402 may be input to a constant on-time generator 404. Output of the constant in-time generator 404 may be input to the logic element 310, which controls the operation of a high-side switch 110 and a low side-switch 120. The further elements and operation of the buck converter 400 of Fig. 4 are similar to the elements and operation of the buck converter 300 described with Fig. 3.

The present disclosure is not limited to buck converters as shown in Fig. 3 or Fig. 4. Other variants of buck converters may make use of the solution of the present disclosure, i.e., implementing a valley current limit circuit such as the valley current limit circuit 200 of Fig. 2.

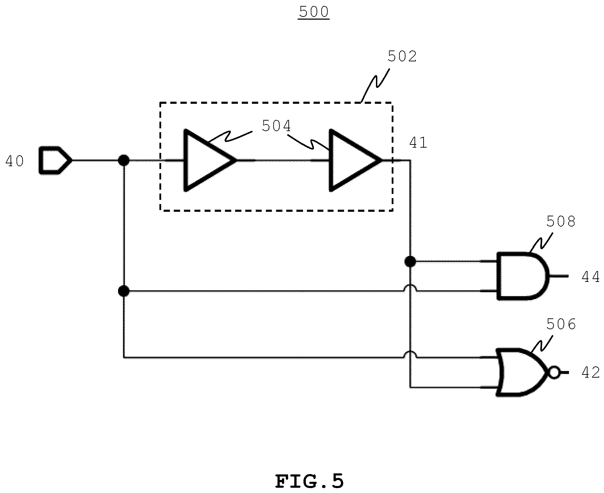

A non-limiting example embodiment of a phase generator 500, such as the phase generator 240 of Fig. 2, is shown in Fig. 5. The phase generator 500 is arranged to generate the first signal 42 (phase A signal) and the second signal 44 (phase B signal) for controlling the ON/OFF states of the switches 252, 254 and to control the comparator 230. Preferably, the first signal 42 and the second signal 44 do not overlap to ensure that the sample and hold capacitor 220 does not accidently discharge and cause error between phases. This is illustrated in Fig. 2, where the phase A signal 42 and the phase B signal 44 are shown in the phase generator 240 as two non-overlapping signals.

The phase generation circuit may implement a clock signal delay and several logic gates to generate the non-overlapping clock phases. In the example of Fig. 5, the phase generator 500 receives a clock signal 40. The clock signal 40 may be delayed by a clock delay circuit 502, e.g., including one or more buffer gates 504, to obtain a delayed clock signal 41. Using the clock delay circuit 502, the clock signal may be delayed ensuring that the phase A signal 42 and phase B signal 44 do not overlap. A non-limiting example of a suitable delay introduced by the clock delay circuit 502 is 3ns, but other time delays may be configured depending on the design constraints of the bucket converter.

The clock signal 40 and delayed clock signal 41 may be input to logic gates to generate the phase A signal 42 and the phase B signal 44. In the example of Fig.5, the phase A signal 42 is generated using a NOR gate 506 on the clock signal 40 and delayed clock signal 41, and the phase B signal 44 is generated using an AND gate 508 on the clock signal 40 and delayed clock signal 41.

The solution of the present disclosure is not limited by the phase generator 500 shown in Fig. 5. Other phase generation circuits may be used to generate the phase A signal 42 and the phase B signal 44.

The high-side switch 110 and a low-side switch 120 may be implemented as a transistor, bipolar junction transistor (BJT), MOSFET, power FET, or any other suitable switch, depending on the preferred implementation of the buck converter.

Any logic signals, such as the phase A signal 42 and the phase B signal 44, may be implemented in any suitable manner, e.g., using 5V/0V signals for HIGH/LOW signals or any other suitable voltage levels.

The solution of the present disclosure may be used in any switching regulators that aim to set a valley inductor current limit.

Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope thereof.

**Claims**

1. A valley current limit circuit of a switching regulator comprising:

   a sample and hold capacitor;
   wherein the valley current limit circuit is arranged to charge the sample and hold capacitor when a low-side switch of the switching regulator is OFF and to provide a negative reference voltage ($V_{REF\_NEG}$) from the sample and hold capacitor when the low-side switch is ON; and
   wherein the valley current limit circuit comprises a comparator arranged to provide a current limit reference ($I_{LIM}$) by comparing the $V_{REF\_NEG}$ against a switch node voltage (Vsw) of the switching regulator when the low-side switch is ON.

2. The valley current limit circuit according to claim 1, wherein the switching regulator is a buck converter.

3. The valley current limit circuit according to claim 1, further comprising a sense field-effect transistor (FET);

   wherein the sense FET has a drain that is connected to a reference voltage ($V_{DD}$);
   wherein the sense FET has a gate that is connected to the $V_{DD}$;
   wherein the sense FET has a source that is connected to ground; and
   wherein one side of the sample and hold capacitor is connected to the drain of the sense FET for charging the sample and hold capacitor using a reference current ($I_{REF}$), and wherein $I_{REF}$ is a result of the $V_{DD}$ on the sense FET.

4. The valley current limit circuit according to claim 2, further comprising a sense field-effect transistor (FET);

   wherein the sense FET has a drain that is connected to a reference voltage ($V_{DD}$);
   wherein the sense FET has a gate that is connected to the $V_{DD}$;
   wherein the sense FET has a source that is connected to ground; and
   wherein one side of the sample and hold capacitor is connected to the drain of the sense FET for charging the sample and hold capacitor using a reference current ($I_{REF}$), and wherein $I_{REF}$ is a result of the $V_{DD}$ on the sense FET.

**EP 4 625 790 A1**

5. The valley current limit circuit according to claim 3, wherein the sense FET and the low-side switch are proportional.

6. The valley current limit circuit according to claim 3, further comprising first switches and second switches;

   wherein the valley current limit circuit is arranged to close the first switches and open the second switches when the low-side switch is OFF, thereby connecting the one side of the sample and hold capacitor to the drain of the sense FET and connecting the other side of the sample and hold capacitor to ground; and
   wherein the valley current limit circuit is arranged to open the first switches and close the second switches when the low-side switch is ON, thereby connecting the one side of the sample and hold capacitor to ground and connecting the other side of the sample and hold capacitor to the comparator.

7. The valley current limit circuit according to claim 5, further comprising first switches and second switches;

   wherein the valley current limit circuit is arranged to close the first switches and open the second switches when the low-side switch is OFF, thereby connecting the one side of the sample and hold capacitor to the drain of the sense FET and connecting the other side of the sample and hold capacitor to ground; and
   wherein the valley current limit circuit is arranged to open the first switches and close the second switches when the low-side switch is ON, thereby connecting the one side of the sample and hold capacitor to ground and connecting the other side of the sample and hold capacitor to the comparator.

8. The valley current limit circuit according to claim 6, further comprising a phase generator, wherein the phase generator is arranged to:

   generate a first signal for controlling switching of the first switches;
   generate a second signal for controlling switching of the second switches; and
   wherein the first signal and the second signal are non-overlapping inverse signals.

9. The valley current limit circuit according to claim 8,

   wherein when the first signal is LOW the second signal is HIGH;
   wherein when the first signal is HIGH the second signal is LOW;
   and
   wherein there is a delay between the first signal and the second signal to ensure that the first signal and the second signal are non-overlapping.

10. The valley current limit circuit according to claim 8, wherein the comparator is arranged to operate under control of the first signal and the second signal.

11. The valley current limit circuit according to claim 9, wherein the comparator is arranged to operate under control of the first signal and the second signal.

12. The valley current limit circuit according to claim 1, wherein the comparator is an auto zero comparator.

13. A switching regulator comprising:

   a high-side switch;
   a low-side switch;
   a switch node (SW) in between the high-side switch and the low-side switch;
   an inductor connected to the SW, the inductor providing an output voltage ($V_{out}$) depending on the high-side switch being turned ON or the low-side switch being turned ON; and
   a valley current limit circuit according to claim 1,
   wherein the valley current limit circuit is arranged to provide a current limit reference ($I_{LIM}$) for regulating a high-side control signal (HSON) for controlling switching of the high-side switch.

14. The switching regulator according to claim 13, wherein the switching regulator is a buck converter.

15. The switching regulator according to claim 13, wherein the high-side switch and the low-side switch are metal-oxide-semiconductor field-effect transistors (MOSFETs).

16. The switching regulator according to claim 13, wherein the valley current limit circuit comprises a sense FET that is proportional to the low-side switch, so that $R_{ds\_low\_side\_switch} : R_{ds\_sense\_FET} = 1:K$.

17. The switching regulator according to claim 14, wherein the high-side switch and the low-side switch are metal-oxide-semiconductor field-effect transistors (MOSFETs).

18. The switching regulator according to claim 14, wherein the valley current limit circuit comprises a sense FET that is proportional to the low-side switch, so that $R_{ds\_low\_side\_switch} : R_{ds\_sense\_FET} = 1:K$.

FIG.1
(Prior Art)

FIG.2

FIG. 3

FIG. 4

FIG.5

## EUROPEAN SEARCH REPORT

Application Number

EP 25 16 6726

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2020/336069 A1 (YAO KAIWEI [US]) 22 October 2020 (2020-10-22) | 1-5, 12-18 | INV. H02M1/00 |
| Y | * paragraph [0017] - paragraph [0022] * <br> * paragraph [0027] * <br> * paragraph [0036] * <br> * figures 2, 3, 7, 8 * | 6-11 | H02M3/158 <br> H02M3/07 |
| Y | US 2010/253296 A1 (HUANG JIN-BIAO [US] ET AL) 7 October 2010 (2010-10-07) <br> * paragraph [0031] - paragraph [0033] * <br> * figures 1-4 * | 6-11 | |
| A | US 2016/211744 A1 (ARAKAWA HIDEKI [JP] ET AL) 21 July 2016 (2016-07-21) <br> * figure 1A * | 6-11 | |
| A | US 6 021 056 A (FORBES ANDREW BRUCE [US] ET AL) 1 February 2000 (2000-02-01) <br> * figures 1, 2 * | 6-11 | |
| A | US 7 701 281 B1 (RAGHAVAN VIJAY [US]) 20 April 2010 (2010-04-20) <br> * figure 1 * | 6-11 | TECHNICAL FIELDS SEARCHED (IPC) <br><br> H02M |
| A | MICHAL VRATISLAV: "Inductor Current Zero-Crossing Detector and CCM/DCM Boundary Detector for Integrated High-Current Switched-Mode DC-DC Conver", IEEE TRANSACTIONS ON POWER ELECTRONICS, INSTITUTE OF ELECTRICAL AND ELECTRONICS ENGINEERS, USA, vol. 29, no. 10, 1 October 2014 (2014-10-01), pages 5384-5391, XP011550011, ISSN: 0885-8993, DOI: 10.1109/TPEL.2013.2292600 [retrieved on 2014-06-02] * abstract * | 12 | |

-/--

The present search report has been drawn up for all claims

| Place of search | Date of completion of the search | Examiner |
|---|---|---|
| The Hague | 29 July 2025 | Madouroglou, E |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

## EUROPEAN SEARCH REPORT

**Application Number**

EP 25 16 6726

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 7 710 084 B1 (GUO YIGANG [US]) 4 May 2010 (2010-05-04) * column 3, line 52 - line 64 * * figure 1 * ----- | 12 | |
| | | | TECHNICAL FIELDS SEARCHED (IPC) |

The present search report has been drawn up for all claims

| Place of search | Date of completion of the search | Examiner |
|---|---|---|
| The Hague | 29 July 2025 | Madouroglou, E |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons
   ...........................................................................................
& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 25 16 6726

This annex lists the patent family members relating to the patent documents cited in the above-mentioned European search report.
The members are as contained in the European Patent Office EDP file on
The European Patent Office is in no way liable for these particulars which are merely given for the purpose of information.

29-07-2025

| Patent document cited in search report | | Publication date | Patent family member(s) | | Publication date |
|---|---|---|---|---|---|
| US 2020336069 | A1 | 22-10-2020 | CN | 110247551 A | 17-09-2019 |
| | | | US | 2020336069 A1 | 22-10-2020 |
| US 2010253296 | A1 | 07-10-2010 | NONE | | |
| US 2016211744 | A1 | 21-07-2016 | CN | 105807835 A | 27-07-2016 |
| | | | JP | 5911614 B1 | 27-04-2016 |
| | | | JP | 2016134989 A | 25-07-2016 |
| | | | TW | 201627792 A | 01-08-2016 |
| | | | US | 2016211744 A1 | 21-07-2016 |
| US 6021056 | A | 01-02-2000 | NONE | | |
| US 7701281 | B1 | 20-04-2010 | US | 7362163 B1 | 22-04-2008 |
| | | | US | 7701281 B1 | 20-04-2010 |
| US 7710084 | B1 | 04-05-2010 | NONE | | |

EPO FORM P0459

For more details about this annex : see Official Journal of the European Patent Office, No. 12/82